# EUROPEAN PATENT APPLICATION

(11) **EP 4 290 587 A1**
(43) Date of publication of application: **13.12.2023**
(21) Application number: 22184872.4
(22) Date of filing: 14.07.2022
(51) Int. Cl.: H01L 31/0224, H01L 31/068, H01L 31/0747

(54) **SOLAR CELL AND PHOTOVOLTAIC MODULE**

(30) Priority: 08.06.2022 CN 202210646083
(71) Applicant: Zhejiang Jinko Solar Co., Ltd., Haining, Zhejiang 314416 (CN); JINKO SOLAR CO., LTD, Jiangxi 334100 (CN)
(72) Inventor: CHEN, Kongsong, HAINING, 314416 (CN); XU, Menglei, HAINING, 314416 (CN); YANG, Jie, HAINING, 314416 (CN); ZHANG, Xinyu, HAINING, 314416 (CN)
(74) Representative: DREISS Patentanwälte PartG mbB

(57) **Abstract**

A solar cell includes: a substrate having front and back surfaces opposite to each other, the back surface includes first regions, second regions and gap regions, the first regions and the second regions are staggered and spaced from each other in a first direction, and each gap region is provided between one first region and one adjacent second region; a first conductive layer formed over the first region; a second conductive layer formed over the second region, the second conductive layer has a conductivity type opposite to the first conductive layer; a first electrode forming electrical contact with the first conductive layer; a second electrode forming electrical contact with the second conductive layer; and first pyramidal texture structures formed on the back surface corresponding to the gap regions. A curved interface region is formed between side wall of the first/second conductive layer and side wall of the adjacent gap region.

## Description

### TECHNICAL FIELD

The present disclosure relates to the technical field of photovoltaic cells, and in particular, to a solar cell and a photovoltaic module.

### BACKGROUND

An Interdigitated Back Contact (IBC) solar cell has a light receiving surface with no electrode arranged thereon, while positive and negative electrodes are arranged in an interdigitated manner on a backlight surface of the solar cell. Compared with the solar cell with a partially shielded light receiving surface, the IBS solar cell has a higher short-circuit current and thus a higher photoelectric conversion efficiency.

How to further improve the efficiency of the IBC solar cell is an urgent technical problem to be solved.

### SUMMARY

An objective of the present disclosure is to provide a solar cell and a photovoltaic module, so as to solve the technical problem in the related art, which can improve the efficiency of the IBC solar cell.

The present disclosure provides a solar cell, including: a substrate having a front surface and a back surface opposite to the front surface, the back surface includes first regions, second regions and gap regions, the first regions and the second regions are staggered and spaced from each other in a first direction, and each gap region is provided between one first region and one second region adjacent to the first region by recessing toward an interior of the substrate; a first conductive layer formed over the first region; a second conductive layer formed over the second region, the second conductive layer has a conductivity type opposite to the first conductive layer; a first electrode forming electrical contact with the first conductive layer; a second electrode forming electrical contact with the second conductive layer; and first pyramidal texture structures formed on the back surface corresponding to the gap regions. A curved interface region is formed between a side wall of the first conductive layer and/or the second conductive layer and a side wall of the gap region adjacent thereto.

In one or more embodiments, the solar cell further includes a back passivation layer formed over a surface of the first conductive layer, a surface of the second conductive layer, and a surface of the gap region, the first electrode penetrate through the back passivation layer to form electrical contact with the first conductive layer, and the second electrode penetrate through the back passivation layer to form electrical contact with the second conductive layer.

In one or more embodiments, a front passivation layer is formed over the front surface of the substrate.

In one or more embodiments, the substrate is an N-type substrate, the first conductive layer includes a P-type doped layer, and the second conductive layer includes an N-type doped layer.

In one or more embodiments, a dielectric layer is formed between at least one of the first conductive layer or the second conductive layer and the back surface of the substrate.

In one or more embodiments, the dielectric layer includes silicon oxide, aluminum oxide, hafnium oxide, silicon nitride, or silicon oxynitride.

In one or more embodiments, the dielectric layer has a thickness in a range of 0.5 nm to 3 nm.

In one or more embodiments, the dielectric layer does not cover the back surface of the substrate corresponding to the gap regions.

In one or more embodiments, a distance between a top surface and a bottom surface of the first pyramidal texture structures ranges from 1 µm to 5 µm.

In one or more embodiments, an extent of the curved interface region in the first direction ranges from 3 µm to 15 µm.

In one or more embodiments, a distance between a top surface and a bottom surface of the curved interface region ranges from 2 µm to 5 µm.

In one or more embodiments, an extent of the gap region in the first direction ranges from 50 µm to 200 µm.

In one or more embodiments, an extent of the gap region in a normal direction of the back surface of the substrate ranges from 1 µm to 6 µm.

In one or more embodiments, at least part of a surface of the curved interface region includes a plurality of protruding texture structures.

In one or more embodiments, a ratio of an area of the gap region to an area of the back surface of the substrate ranges from 10% to 35%.

The present disclosure further provides a method for manufacturing a solar cell, including the following steps: providing a substrate having a front surface and a back surface opposite to the front surface, the back surface includes first regions, second regions and gap regions, the first regions and the second regions are staggered and spaced from each other in a first direction, and each gap region is provided between one first region and one second region adjacent to the first region by recessing toward an interior of the substrate; forming a first conductive layer over the back surface of the substrate; performing laser ablation over the back surface of the substrate to remove the first conductive layer located in the second region and the gap region; forming a second conductive layer over the back surface of the substrate; forming a first protective layer over a surface of the second conductive layer corresponding to the second region; removing the second conductive layer not covered by the first protective layer; removing the first protective layer; performing texturing to form first pyramidal texture structures on the back surface corresponding to the gap regions, a curved interface region is formed between a side wall of the first conductive layer and/or the second conductive layer and a side wall of the gap region adjacent thereto; and forming a first electrode on the first conductive layer, and forming a second electrode on the second conductive layer.

The present disclosure further provides a photovoltaic module, including: a solar cell string including a plurality of solar cells; an encapsulation layer covering a surface of the solar cell string; and a cover plate covering a surface of the encapsulation layer facing away from the solar cell string. At least one of the plurality of solar cells includes: a substrate having a front surface and a back surface opposite to the front surface, the back surface includes first regions, second regions and gap regions, the first regions and the second regions are staggered and spaced from each other in a first direction, and each gap region is provided between one first region and one second region adjacent to the first region by recessing toward an interior of the substrate; a first conductive layer formed over the first region; a second conductive layer formed over the second region, the second conductive layer has a conductivity type opposite to the first conductive layer; a first electrode forming electrical contact with the first conductive layer; a second electrode forming electrical contact with the second conductive layer; and first pyramidal texture structures formed on the back surface corresponding to the gap regions. A curved interface region is formed between a side wall of the first conductive layer and/or the second conductive layer and a side wall of the gap region adjacent thereto.

### BRIEF DESCRIPTION OF DRAWINGS

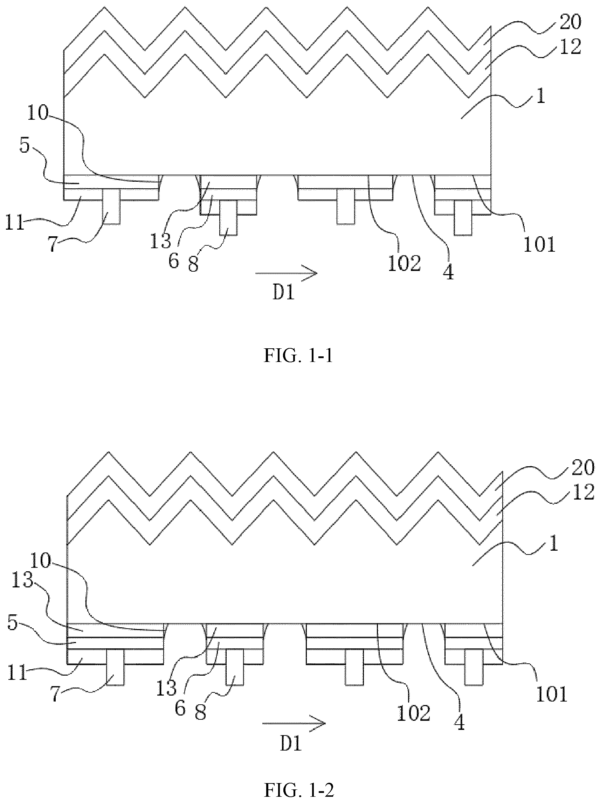

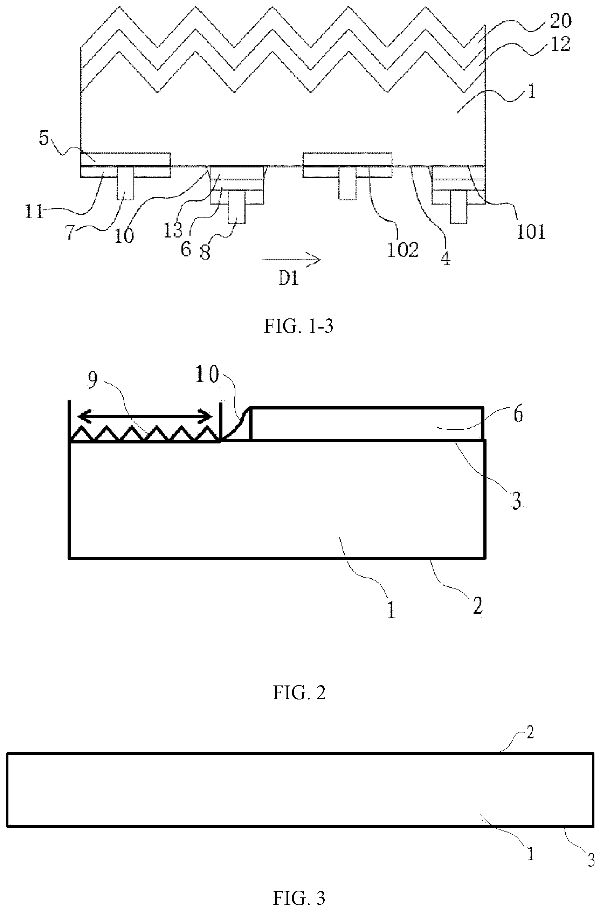

FIG. 1-1 is a schematic structural diagram of a solar cell according to one or more embodiments of the present disclosure;
FIG. 1-2 is another schematic structural diagram of the solar cell according to one or more embodiments of the present disclosure;
FIG. 1-3 is another schematic structural diagram of the solar cell according to one or more embodiments of the present disclosure;
FIG. 2 is a schematic diagram of a partial structure of a solar cell according to one or more embodiments of the present disclosure;
FIG. 3 is a first schematic structural diagram of a solar cell during manufacturing according to one or more embodiments of the present disclosure;
FIG. 4 is a second schematic structural diagram of a solar cell during manufacturing according to one or more embodiments of the present disclosure;
FIG. 5 is a third schematic structural diagram of a solar cell during manufacturing according to one or more embodiments of the present disclosure;
FIG. 6 is a fourth schematic structural diagram of a solar cell during manufacturing according to one or more embodiments of the present disclosure;
FIG. 7 is a fifth schematic structural diagram of a solar cell during manufacturing according to one or more embodiments of the present disclosure;
FIG. 8 is a sixth schematic structural diagram of a solar cell during manufacturing according to one or more embodiments of the present disclosure;
FIG. 9 is a seventh schematic structural diagram of a solar cell during manufacturing according to one or more embodiments of the present disclosure;
FIG. 10 is an eighth schematic structural diagram of a solar cell during manufacturing according to one or more embodiments of the present disclosure;
FIG. 11 is a ninth schematic structural diagram of a solar cell during manufacturing according to one or more embodiments of the present disclosure;
FIG. 12 is a tenth schematic structural diagram of a solar cell during manufacturing according to one or more embodiments of the present disclosure;
FIG. 13 is an eleventh schematic structural diagram of a solar cell during manufacturing according to one or more embodiments of the present disclosure;
FIG. 14 is a twelfth schematic structural diagram of a solar cell during manufacturing according to one or more embodiments of the present disclosure;
FIG. 15 is a thirteenth schematic structural diagram of a solar cell during manufacturing according to one or more embodiments of the present disclosure; and
FIG. 16 is a schematic structural diagram of a photovoltaic module according to one or more embodiments of the present disclosure.

### DESCRIPTION OF EMBODIMENTS

Embodiments described below with reference to the accompanying drawings are illustrative and are only intended to explain the present disclosure and shall not be interpreted as limitations on the present disclosure.

An interdigitated back contact solar cell is also referred to as an IBC solar cell. There is a strict requirement on a pitch width of the IBC solar cell. A wider pitch may affect transport and collection of minority carriers. Under an identical pitch width, a ratio of an emitter to a base may also affect the efficiency of the solar cell. How to improve the efficiency of the IBC solar cell without changing a ratio of p+ to n+ of each pitch width at the back surface of the IBC solar cell is an urgent technical problem to be solved.

In order to solve the above technical problem, an embodiment of the present disclosure provides a solar cell. The solar cell is an IBC solar cell. As shown in FIG. 1-1, FIG. 1-2 or FIG. 1-3, the solar cell at least includes a substrate 1, a first conductive layer 5, a second conductive layer 6, a first electrode 7, and a second electrode 8.

The substrate 1 has a front surface 2 and a back surface 3 opposite to the front surface 2. The front surface 2 is a light receiving surface facing the direction of sunlight, and the back surface 3 is a surface opposite to the front surface 2.

The substrate 1 may be, for example, a crystalline semiconductor (e.g., crystalline silicon) including a dopant of a first conductivity type. The crystalline semiconductor may be monocrystalline silicon, and the dopant of the first conductivity type may be an N-type dopant including Group V elements such as phosphorus (P), arsenic (As), bismuth (Bi), and stibium (Sb), or a P-type dopant including Group III elements such as boron (B), aluminum (Al), gallium (Ga), and indium (In).

The back surface 3 has first regions 101 and second regions 102 staggered and spaced from each other in a first direction D1. Gap regions 4 recessed toward the interior of the substrate 1 are provided between adjacent first and second regions 101, 102. The first conductive layer 5 is formed over the first region 101. The second conductive layer 6 is formed over the second region 102. The second conductive layer 6 is of a conductivity type opposite to the first conductive layer 5. The gap region 4 is configured to physically separate the first conductive layer 5 from the second conductive layer 6, so that the first conductive layer 5 is insulated from the second conductive layer 6 or the first electrode 7 is insulated from the second electrode 8 to prevent short circuit of positive and negative electrodes of the solar cell or leakage of the solar cell, thereby improving reliability of the solar cell.

The first electrode 7 forms electrical contact with the first conductive layer 5, and the second electrode 8 forms electrical contact with the second conductive layer 6. In some embodiments, the first electrode 7 and the second electrode 8 are made from at least one conductive metal material such as silver, aluminum, copper, and nickel.

A plurality of first pyramidal texture structures are formed on the back surface 3 corresponding to the gap region 4. The first pyramidal texture structures may be formed through a texturing (or etching) process. The texturing process may be any one of chemical etching, laser ablation, mechanical etching, plasma etching, or the like. The first pyramidal texture structures have good light trapping and antireflection effects, so that light incident on the back surface 3 can also be utilized, which increases an effective contact area of the light, realizes further utilization of light energy, and improves power generation efficiency of the solar cell.

In some embodiments, a plurality of first pyramidal texture structures such as stepped flat texture structures or square frustum texture structures are formed on the back surface 3 corresponding to the first regions 101 and the second regions 102, respectively.

A curved interface region 10 exists between a side wall of the first conductive layer 5 and/or the second conductive layer 6 and a side wall of the gap region adjacent thereto 4. Taking FIG. 2 as an example, a curved interface region 10 is provided between the side wall of the second conductive layer 6 and a side wall of a gap region 4 adjacent thereto. The curved interface region 10 forms a smooth wall connection, so as to form different light trapping structures with surfaces of the first pyramidal texture structures 9 on the gap regions 4, which can increase reflection of incident light on the back surface 3 of the substrate land increase the amount of light absorbed by the solar cell, without affecting passivation effect of the gap region 4, so that the light can be reused by the solar cell, thereby improving photoelectric conversion efficiency of the IBC solar cell. In some embodiments, "smooth" may refer to that roughness of the curved interface region 10 is less than the first pyramidal texture structure 9 or the roughness of the curved interface region 10 is less than a set threshold. In some embodiments, the second conductive layer 6 and the gap region adjacent thereto as shown in FIG. 2 have a similar structure, and a curved interface region 10 may also exist between the side wall of the first conductive layer 5 and a side wall of the gap region 4 adjacent thereto.

As shown in FIG. 1-1 or FIG. 1-2, the solar cell is an N-type solar cell. That is, the substrate 1 is an N-type crystalline silicon substrate, the first conductive layer 5 includes a P-type doped layer (i.e., emitter), and the second conductive layer 6 includes an N-type doped layer (i.e., base).

In some embodiments, as shown in FIG. 1-1, the first conductive layer 5 is formed inside or over the back surface 3 of the substrate 1. For example, the first conductive layer 5 is formed by doping a preset region of the back surface 3 of the substrate 1 with a P-type dopant by means of such as deposition, diffusion, or printing. In this case, the P-type dopant has any impurity of a conductivity type opposite to the substrate 1. That is, a Group III element such as boron (B), aluminum (Al), gallium (Ga), or indium (In) may be used. The first conductive layer 5 has a same crystal structure as the substrate 1, for example, monocrystalline silicon. A dielectric layer 13 is arranged between the second conductive layer 6 and the substrate 1. In some embodiments of the present disclosure, the dielectric layer 13 includes one or more of silicon oxide, aluminum oxide, hafnium oxide, silicon nitride, or silicon oxynitride. The second conductive layer 6 is formed by doping amorphous silicon, microcrystalline silicon, or polycrystalline silicon with an N-type dopant. The N-type dopant may be any dopant having a same conductivity type as the substrate 1. That is, a Group V element such as phosphorus (P), arsenic (As), bismuth (Bi), or stibium (Sb) may be used. In some embodiments, the second conductive layer 6 is a phosphorus-doped polysilicon layer. The second conductive layer 6 has a different crystal structure from the substrate 1.

In some embodiments, as shown in FIG. 1-2, the second conductive layer 6 is the same as the second conductive layer 6 in FIG. 1-1, which is not described in detail herein. A difference is that the dielectric layer 13 is also arranged between the first conductive layer 5 and the substrate 1. As an optional technical solution of the present disclosure, the dielectric layer 13 includes one or more of silicon oxide, aluminum oxide, hafnium oxide, silicon nitride, and silicon oxynitride, and the first conductive layer 5 is formed by doping amorphous silicon, microcrystalline silicon, or polycrystalline silicon with a P-type dopant. That is, a P-type dopant of a Group III element such as boron (B), aluminum (Al), gallium (Ga), or indium (In) may be used. In an embodiment, the first conductive layer 5 is a phosphorus-doped polysilicon layer. The first conductive layer 5 has a different crystal structure from the substrate 1.

In some embodiments, referring to FIG. 1-3, the solar cell is a P-type solar cell. That is, the substrate 1 is a P-type crystalline silicon substrate, the first conductive layer 5 includes a P-type doped layer (i.e., base), and the second conductive layer 6 includes an N-type doped layer (i.e., emitter).

The P-type doped layer may form an opening above the substrate 1 through a process such as laser ablation, dry etching, wet etching, or mechanical etching to expose the P-type crystalline silicon substrate, and then the first electrode 7 may be directly formed on the back surface 3 of the P-type crystalline silicon substrate, so that the first electrode 7 comes into contact with the back surface 3 to facilitate metal atoms in the first electrode 7 to be diffused into the back surface 3 to form a base layer. The P-type doped layer includes an alloy layer (e.g., an Al-Si alloy layer) formed by a metal electrode and the substrate 1.

A dielectric layer 13 is arranged between the second conductive layer 6 and the substrate 1. In some embodiments of the present disclosure, the dielectric layer 13 includes one or more of silicon oxide, aluminum oxide, hafnium oxide, silicon nitride, or silicon oxynitride. The second conductive layer 6 is formed by doping amorphous silicon, microcrystalline silicon, or polycrystalline silicon with an N-type dopant. The N-type dopant may be any dopant having a same conductivity type as the substrate 1. That is, a Group V element such as phosphorus (P), arsenic (As), bismuth (Bi), or stibium (Sb) may be used.

In an embodiment of the present disclosure, the structure of the IBC solar cell according to the present disclosure is described with an example in which the substrate 1 is an N-type crystalline silicon substrate.

Referring to FIG. 1-1, FIG. 14, and FIG. 15, the solar cell further includes a back passivation layer 11. The back passivation layer 11 may perform passivation on the back surface of the solar cell and dangling bonds at the first conductive layer 5, the second conductive layer 6, and the gap region 4, which reduces the carrier recombination speed of the back surface 3 and improves the photoelectric conversion efficiency. The back passivation layer 11 is located over surfaces of the first conductive layer 5, the second conductive layer 6, and the gap region 4. The first electrode 7 penetrates through the back passivation layer 11 to form electrical contact with the first conductive layer 5. The second electrode 8 penetrates through the back passivation layer 11 to form electrical contact with the second conductive layer 6.

In some embodiments of the present disclosure, the back passivation layer 11 may be provided with an opening to allow the first electrode 7 and the second electrode 8 to pass therethrough to electrically contact with the first conductive layer 5 and the second conductive layer 6 respectively, so as to reduce a contact area among the metal electrode, the first conductive layer 5 and the second conductive layer 6, which further reduces the contact resistance, and thus increases an open-circuit voltage.

In some embodiments, the back passivation layer 11 includes a stack structure of at least one or more of a silicon oxide layer, a silicon nitride layer, an aluminum oxide layer, or a silicon oxynitride layer.

In some embodiments, the back passivation layer 11 has a thickness in a range of 10 nm to 120 nm, which may be, for example, 10 nm, 20 nm, 30 nm, 40 nm, 50 nm, 60 nm, 70 nm, 80 nm, 90 nm, 100 nm, 120 nm, or the like, and may also be other values in the range, which is not limited herein.

In some embodiments, a front passivation layer 12 is formed over the front surface 2 of the substrate 1. The front passivation layer 12 may perform passivation on the front surface 2 of the substrate 1, which reduces recombinations of carriers at an interface and improves transport efficiency of the carriers, thereby improving the photoelectric conversion efficiency of the IBC solar cell.

In some embodiments, the front passivation layer 12 includes a stack structure of at least one or more of a silicon oxide layer, a silicon nitride layer, an aluminum oxide layer, or a silicon oxynitride layer.

In some embodiments, an antireflection layer 20 is further provided over a surface of the front passivation layer 12. The antireflection layer 20 may reduce reflection of incident light and improve refraction of light, thereby improving the utilization of the light and the photoelectric conversion efficiency. In some embodiments, similar to the antireflection layer 20, the front passivation layer 12 may also reduce the reflection of the incident light.

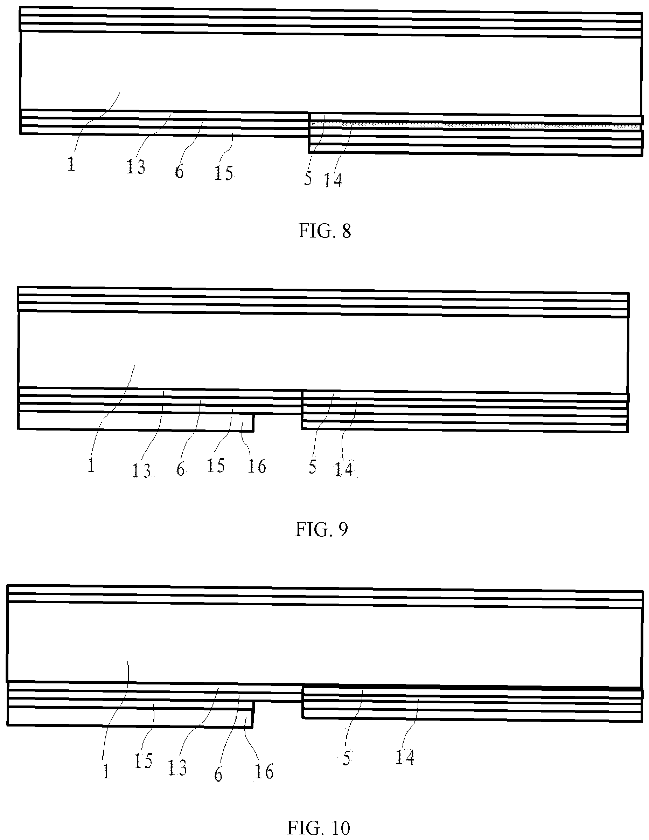

In some embodiments, an ultra-thin dielectric layer 13 is arranged between at least one of the first conductive layer 5 and the second conductive layer 6 or the back surface 3 of the substrate 1. The dielectric layer 13 is configured to perform passivation on an interface of the back surface 3 of the substrate 1, which reduces recombinations of carriers at the interface and ensures transport efficiency of the carriers. In some embodiments, referring to FIG. 8 to FIG. 15, the dielectric layer 13 is arranged between the second conductive layer 6 and the back surface 3 of the substrate 1.

In some embodiments of the present disclosure, the dielectric layer 13 includes one or more of silicon oxide, aluminum oxide, hafnium oxide, silicon nitride, or silicon oxynitride.

In some embodiments, the dielectric layer 13 has a thickness in a range of 0.5 nm to 3 nm. If the thickness of the dielectric layer 13 is excessively large, a tunneling effect of majority carriers will be affected, and it is difficult to transport the carriers through the dielectric layer 13, thereby affecting tunneling and passivation effects of the dielectric layer 13 and may gradually decrease the photoelectric conversion efficiency of the solar cell. If the thickness of the dielectric layer 13 is excessively small, it is not conducive to contact with electrode slurry. The dielectric layer 13 has a thickness in a range of 0.5 nm to 3 nm. For example, the thickness of the dielectric layer 13 may be 0.5 nm, 0.9 nm, 1.0 nm, 1.2 nm, 1.4 nm, 1.6 nm, 1.8 nm, 2.0 nm, 2.2 nm, 2.4 nm, 2.6 nm, 2.8 nm, 3 nm, or the like, may also be other values in the range, which is not limited herein.

In some embodiments, the dielectric layer 13 does not cover the back surface 3 of the substrate 1 corresponding to the gap region 4. When the first conductive layer 5 is a P-type doped layer and the second conductive layer 6 is an N-type doped layer, the dielectric layer 13 is a tunnel oxide layer. The tunnel oxide layer allows majority carriers to tunnel into the first conductive layer 5 and the second conductive layer 6 and blocks the passage of minority carriers. Then the majority carriers are transported transversally within the first conductive layer 5 and the second conductive layer 6 and collected by the first electrode 7 or the second electrode 8. The tunnel oxide layer forms a tunnel oxide passivated contact structure with the first conductive layer 5 and the second conductive layer 6, which can achieve excellent interface passivation and selective collection of carriers, reduce the recombinations of the carriers, and improve the photoelectric conversion efficiency of the solar cell. It is to be noted that the tunnel oxide layer may not have a perfect tunnel barrier in practice because it may include, for example, defects such as pinholes, which may cause other charge carrier transport mechanisms (such as drift, diffusion) to dominate the tunnel effect.

In some embodiments, a distance between a top surface and a bottom surface of the first pyramidal texture structures 9 ranges from 1 µm to 5 µm. For example, the distance may be 1 µm, 1.5 µm, 2.0 µm, 3.0 µm, 3.5 µm, 4.0 µm, 4.5 µm, 5.0 µm, or the like, may also be other values in the range, which is not limited herein. When the distance between the top surface and the bottom surface of the first pyramidal texture structures 9 is limited to the above range, the first pyramidal texture structures 9 have good light trapping and antireflection effects, enabling further improvement of the photoelectric conversion efficiency.

In some embodiments, a distance of the curved interface region 10 in the first direction D1 ranges from 3 µm to 15 µm. For example, the distance may be 3 µm, 5 µm, 7 µm, 9 µm, 11 µm, 13 µm, 15 µm, or the like, may also be other values in the range, which is not limited herein. Within the range, reflection of incident light can be increased, and the amount of light absorbed by the solar cell can be increased, thereby improving conversion efficiency of the IBC solar cell. If the distance is excessively small, the effect cannot be significantly improved. If the distance is excessively large, an effective area of the back surface 3 is wasted, thus reducing the performance of the solar cell.

In some embodiments, a distance between a top surface and a bottom surface of the curved interface region 10 ranges from 2 µm to 5 µm. For example, the distance may be 1 µm, 1.5 µm, 2.0 µm, 3.0 µm, 3.5 µm, 4.0 µm, 4.5 µm, 5.0 µm, or the like, may also be other values in the range, which is not limited herein. When the distance between the top surface and the bottom surface of the curved interface region 10 is limited to the above range, the curved interface region 10 can increase reflection of incident light, enabling further improvement of the photoelectric conversion efficiency.

In some embodiments, upon verification, when the incident light has a wavelength in a range of 900 nm to 1200 nm, reflectivity of the incident light at the back of the solar cell can be increased by 1% to 5% due to the addition of the surface structure to the interface region. As a result, more incident light reaches the back of the solar cell, and then is reflected and absorbed again into the substrate 1, further improving the photoelectric conversion efficiency by 0.05% to 0.1%.

In some embodiments, a distance of the gap region 4 in the first direction D1 ranges from 50 µm to 200 µm. For example, the distance may be 50 µm, 70 µm, 90 µm, 110 µm, 130 µm, 150 µm, 170 µm, 190 µm, 200 µm, or the like, may also be other values in the range, which is not limited herein. If the gap region 4 is excessively wide, the effective area of the back surface 3 may be wasted, and it is difficult to collect effective carriers, thus reducing the performance of the solar cell. If the gap region 4 is excessively narrow, good positive and negative insulation cannot be achieved.

In some embodiments, a distance of the gap region 4 in a normal direction of the back surface 3 of the substrate ranges from 1 µm to 6 µm. For example, the distance may be 1 µm, 2 µm, 3 µm, 4 µm, 5 µm, 6 µm, or the like, may also be other values in the range, which is not limited herein.

In some embodiments, at least part of a surface of the curved interface region 10 has a plurality of protruding texture structures. The protruding texture structures may include non-pyramid structures such as strips, diamonds, squares, and trapezoids or irregular polygon plane structures.

In some embodiments, a ratio of an area of the gap region 4 to an area of the back surface 3 of the substrate 1 ranges from 10% to 35%. For example, the ratio may be 10%, 15%, 20%, 25%, 30%, 35%, or the like, may also be other values in the range, which is not limited herein. If the area of the gap region 4 is excessively large, the effective area of the back surface 3 may be wasted, and it is difficult to collect effective carriers, thus reducing the performance of the solar cell. If the area of the gap region 4 is excessively small, good positive and negative pole insulation cannot be achieved.

Based on the above embodiments, the present disclosure further provides a method for manufacturing an N-type solar cell, including the following steps.
Providing a substrate 1 having a front surface 2 and a back surface 3 opposite to the front surface 2, the back surface 3 has first regions 101 and second regions 102 staggered and spaced from each other in a first direction D1, gap regions 4 are provided between the first regions 101 and the second regions 102 adjacent to each other;
Forming a first conductive layer 5 over the back surface 3 of the substrate 1;
Performing laser ablation on the back surface 3 of the substrate 1 to remove the first conductive layer 5 located in the second region 102 and the gap region 4;
Forming a second conductive layer 6 over the back surface 3 of the substrate 1;
Forming a first protective layer 16 over a surface of the second conductive layer 6 corresponding to the second region 102;
Removing the second conductive layer 6 not covered by the first protective layer 16;
Removing the first protective layer 16;
Performing texturing to form a plurality of first pyramidal texture structures 9 on the back surface 3 corresponding to the gap region 4, a curved interface region 10 is formed between a side wall of the first conductive layer 5 and/or the second conductive layer 6 and a side wall of the gap regions 4 adjacent thereto; and
Forming a first electrode 7 on the first conductive layer 5, and forming a second electrode 8 on the second conductive layer 6.

By use of the solar cell manufactured with the above manufacturing method, since the design of a partial structure of the IBC solar cell is optimized, and a curved interface region 10 is formed between a side wall of the first conductive layer 5 and/or the second conductive layer 6 and a side wall of the gap regions 4 adjacent thereto, so as to increase reflection of incident light on the back surface 3 of the substrate 1, increase the amount of light absorbed by the solar cell, and thus improve conversion efficiency of the solar cell.

The solution is specifically introduced below.

In step S10, referring to FIG. 3, the substrate 1 is an N-type crystalline silicon substrate, the front surface 2 is a light receiving surface facing the direction of sunlight, the back surface 3 is a surface opposite to the front surface 2, the first conductive layer 5 is formed over the first region 101, and the second conductive layer 6 is formed over the second region 102. The second conductive layer 6 is of a conductivity type opposite to the first conductive layer 5, and the gap region 4 is configured to separate the first conductive layer 5 from the second conductive layer 6 to improve insulating properties of positive and negative poles, prevent leakage of the solar cell, and thus improve reliability of the solar cell.

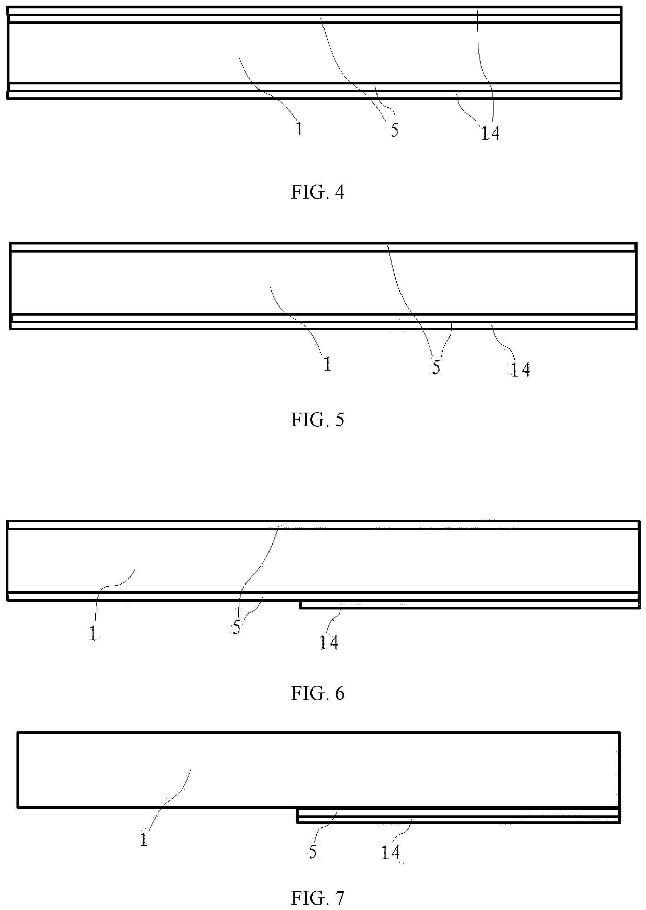

In step S20, referring to FIG. 4 and FIG. 5, the substrate 1 is textured, and a first conductive layer 5 is formed over the back surface 3 of the substrate 1. In some embodiments of the present disclosure, the first conductive layer 5 includes a P-type doped layer (i.e., emitter). Boron is doped into the substrate 1 through a diffusion process. The first conductive layer 5 is formed over the back surface 3 of the N-type silicon substrate 1, with diffusion sheet resistance in a range of 70 ohm/sq to 120 ohm/sq. BSG is also formed by diffusion on the doped layer. A BSG layer 14 plays a role of isolation to better protect the first conductive layer 5. It may be understood that, in a boron diffusion process, a P-type doped layer and part of the BSG layer 14 may also be formed over the front surface 2 of the substrate 1, and this part of BSG is required to be removed. For example, the BSG layer 14 on the front surface 2 is removed using chain HF acid with concentration in a range of 2% to 15%.

In step S30, referring to FIG. 6 and FIG. 7, laser opening mask is performed on the back surface 3 of the substrate 1 to remove the first conductive layer 5 located in the second region 102 and the gap region 4. In an embodiment, laser opening mask is performed on the back surface 3 first. A laser opening mask pattern is interdigitated. Corresponding to a sum of the second region 102 and the gap region 4, the BSG layer 14 in the corresponding regions is removed, and then laser damages are removed by polishing. For example, a polishing temperature is in a range of 50°C to 65°C, polishing time is less than 800 s, a polishing solution includes NaOH with a volume fraction in a range of 1% to 3% or KOH with a volume fraction in a range of 1% to 3% and additives with a volume fraction in a range of 0.5% to 2.5%, and a polishing depth is in a range of 2 µm to 5 µm.

In step S40, referring to FIG. 8, a second conductive layer 6 is formed over the back surface 3 of the substrate 1. The second conductive layer 6 includes an N-type doped layer (i.e., base). In an embodiment, a dielectric layer 13 (tunnel oxide layer) is first grown by thermal oxidation. The dielectric layer 13 has a thickness in a range of 0.1 nm to 1 nm. Intrinsic polysilicon is deposited on the tunnel oxide layer by low pressure chemical vapor deposition. The polysilicon has a thickness in a range of 100 nm to 200 nm. Phosphorus is doped into the intrinsic polysilicon through a diffusion process. A passivated contact structure is formed at the back of the N-type silicon substrate 1. The passivated contact structure is a stacked layer of the dielectric layer 13 and the second conductive layer 6. The second conductive layer 6 has sheet resistance in a range of 25 ohm/sq to 45 ohm/sq. PSG is also formed on the N-type polysilicon by diffusion. A PSG layer 15 may serve as a barrier layer, and has a thickness in a range of 10 nm to 40 nm.

In step S50, referring to FIG. 9, a first protective layer 16 is formed over the surface of the second conductive layer 6 corresponding to the second region 102. In some embodiments, the first protective layer 16 is an INK protective layer. The PSG layer 15 of the second conductive layer 6 is coated with an interdigitated INK protective layer by screen printing or ink-jet coating. A pattern of the INK protective layer is an electrode pattern of the IBC solar cell.

In step S60, the second conductive layer 6 not covered by the first protective layer 16 is removed, and then the first protective layer 16 is removed. Then, texturing is performed to form a plurality of first pyramidal texture structures 9 on the back surface 3 corresponding to the gap region 4, and a curved interface region 10 exists between a side wall of the first conductive layer 5 and/or the second conductive layer 6 and a side wall of the gap regions 4 adjacent thereto.

In S601, referring to FIG. 10, the PSG layer 15 not covered by the first protective layer 16 is corroded with HF acid with a volume fraction in a range of 2% to 15%, and corrosion time is less than 60 s.

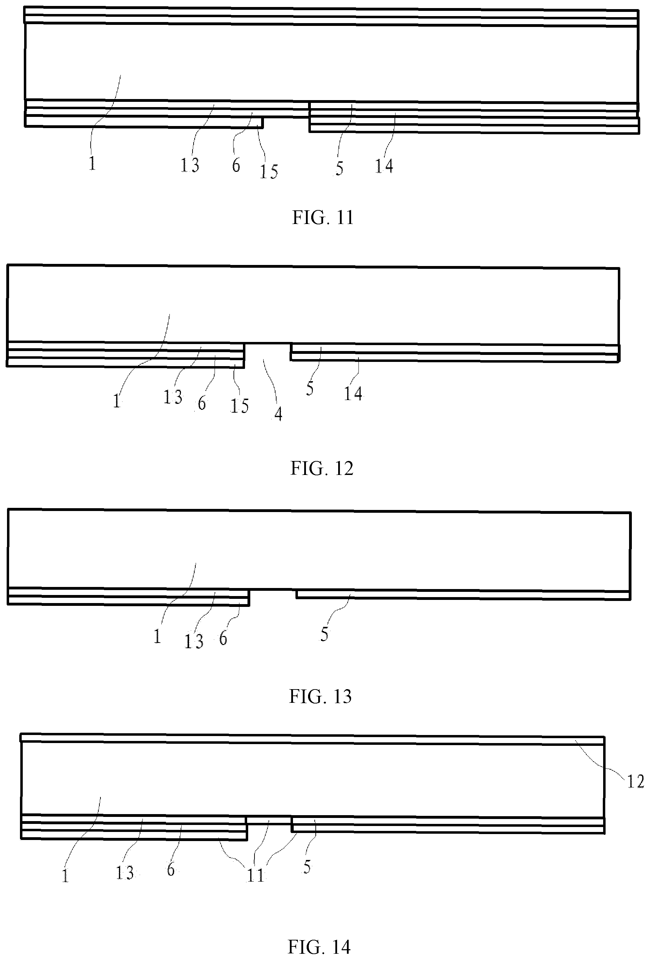

In S602, referring to FIG. 11, after the PSG layer 15 not covered by the first protective layer 16 is removed, the first protective layer 16 is washed off with an alkaline solution. The alkaline solution includes NaOH with a volume fraction in a range of 2% to 5% or KOH with a volume fraction in a range of 2% to 5% and additives with a volume fraction in a range of 3% to 7%, and cleaning time is less than 350 s.

In S603, referring to FIG. 12, the region not covered by the first protective layer 16 is textured with a texturing solution. The texturing solution does not react with the BSG layer 14 and the PSG layer 15, and the first conductive layer 5 and the dielectric layer 13 not covered by the first protective layer 16 can be removed so as to texture the gap regions 4 on the front surface 2 and the back surface 3 of the substrate 1. A texturing temperature is in a range of 70°C to 80°C, and texturing time is less than 450 s. The texturing solution includes NaOH with a volume fraction in a range of 1% to 2% or KOH with a volume fraction in a range of 1% to 2% and additives with a volume fraction in a range of 0.5% to 1%.

In S603, referring to FIG. 13, RCA cleaning is performed on the textured substrate 1, followed by cleaning in an HF solution with concentration in a range of 1% to 10% to clean the surface of the substrate 1 and remove the dielectric layer 13, the BSG layer 14, and the PSG layer 15 on the surface of the substrate 1, so as to form different morphologies in different regions of the back surface 3. First pyramidal texture structures 9 are formed in the gap region 4, and a distance (or height) between the top and the bottom of the first pyramidal texture structures 9 ranges from 2 µm to 5 µm. A curved interface region 10 with non-pyramid texture is formed at an interface of the gap region 4 and the second conductive layer 6. The curved interface region 10 has a width in a range of 3 µm to 15 µm, and a height in a range of 2 µm to 5 µm.

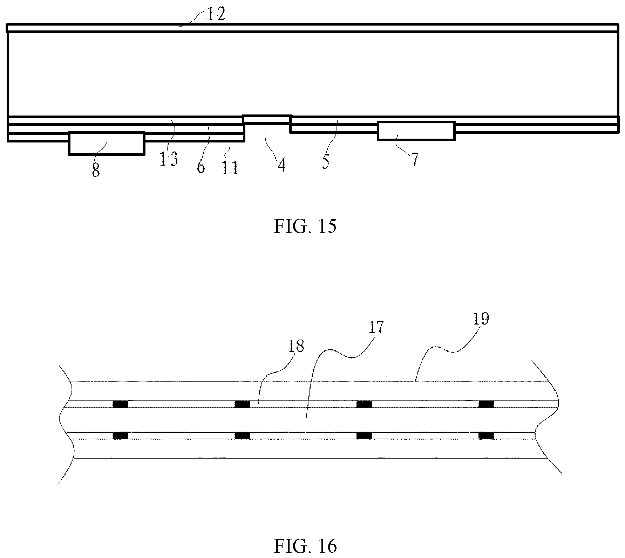

In step S70, referring to FIG. 14 and FIG. 15, a front passivation layer 12 and a back passivation layer 11 are deposited on the front surface 2 and the back surface 3 of the substrate 1, respectively. The front passivation layer 12 is a stacked layer of aluminum oxide, silicon oxide, and silicon nitride, and the back passivation layer 11 is aluminum oxide and silicon nitride. Silver aluminum slurry and silver slurry are printed on the back surface 3 of the substrate 1. The silver aluminum slurry is printed and aligned with the first conductive layer 5 to form the first electrode 7, and the silver slurry is aligned with the second conductive layer 6 to form the second electrode 8, which are sintered to complete metallization.

Based on the above embodiments, referring to FIG. 16, the present disclosure further provides a photovoltaic module, including: solar cell strings 17, the solar cells described above are connected to form the solar cell strings 17, and adjacent solar cell strings 17 are connected by a conductive strip such as a solder strip; an encapsulation layer 18, the encapsulation layer 18 is configured to cover surfaces of the solar cell strings 17; and a cover plate 9 configured to cover a surface of the encapsulation layer 18 away from the solar cell strings 17.

In some embodiments, at least two solar cell strings 17 are provided. The solar cell strings 17 are electrically connected in parallel and/or in series.

In some embodiments, the encapsulation layer 18 includes encapsulation layers arranged on the front and back of the solar cell strings 17. Materials of the encapsulation layer 18 include, but are not limited to, EVA, POE, and PET films.

In some embodiments, the cover plate 19 includes cover plates 19 arranged on the front and back of the solar cell strings 17. Materials with good light transmittance are selected for the cover plate 19, including but not limited to glass, plastic, and the like.

The structure, features and effects of the present disclosure are described in detail above according to the embodiments shown in the drawings. The above are only preferred embodiments of the present disclosure, but the present disclosure does not limit the scope of implementation as illustrated in the drawings. Any changes made in accordance with the conception of the present disclosure, or equivalent embodiments modified as equivalent changes, shall fall within the protection scope of the present disclosure.

## Claims

1. A solar cell, comprising:
a substrate having a front surface and a back surface opposite to the front surface, wherein the back surface includes first regions, second regions and gap regions, the first regions and the second regions are staggered and spaced from each other in a first direction, and each gap region is provided between one first region and one second region adjacent to the first region by recessing toward an interior of the substrate;
a first conductive layer formed over the first region;
a second conductive layer formed over the second region, wherein the second conductive layer has a conductivity type opposite to the first conductive layer;
a first electrode forming electrical contact with the first conductive layer;
a second electrode forming electrical contact with the second conductive layer; and
first pyramidal texture structures formed on the back surface corresponding to the gap regions, wherein a curved interface region is formed between a side wall of the first conductive layer and/or the second conductive layer and a side wall of the gap region adjacent thereto.

2. The solar cell according to claim 1, further comprising a back passivation layer formed over a surface of the first conductive layer, a surface of the second conductive layer, and a surface of the gap region, wherein the first electrode penetrate through the back passivation layer to form electrical contact with the first conductive layer, and the second electrode penetrate through the back passivation layer to form electrical contact with the second conductive layer.

3. The solar cell according to claim 1, wherein a front passivation layer is formed over the front surface of the substrate.

4. The solar cell according to claim 1, wherein the substrate is an N-type substrate, the first conductive layer comprises a P-type doped layer, and the second conductive layer comprises an N-type doped layer.

5. The solar cell according to claim 1, wherein a dielectric layer is formed between at least one of the first conductive layer or the second conductive layer and the back surface of the substrate.

6. The solar cell according to claim 5, wherein the dielectric layer comprises silicon oxide, aluminum oxide, hafnium oxide, silicon nitride, or silicon oxynitride.

7. The solar cell according to claim 5, wherein the dielectric layer has a thickness in a range of 0.5 nm to 3 nm.

8. The solar cell according to claim 5, wherein the dielectric layer does not cover the back surface of the substrate corresponding to the gap regions.

9. The solar cell according to claim 1, wherein a distance between a top surface and a bottom surface of the first pyramidal texture structures ranges from 1 µm to 5 µm.

10. The solar cell according to claim 1, wherein an extent of the curved interface region in the first direction ranges from 3 µm to 15 µm, or a distance between a top surface and a bottom surface of the curved interface region ranges from 2 µm to 5 µm.

11. The solar cell according to claim 1, wherein an extent of the gap region in the first direction ranges from 50 µm to 200 µm, or an extent of the gap region in a normal direction of the back surface of the substrate ranges from 1 µm to 6 µm.

12. The solar cell according to claim 1, wherein at least part of a surface of the curved interface region includes a plurality of protruding texture structures.

13. The solar cell according to claim 1, wherein a ratio of an area of the gap region to an area of the back surface of the substrate ranges from 10% to 35%.

14. A photovoltaic module, comprising:
a solar cell string including a plurality of solar cells, wherein at least one of the plurality of solar cells is the solar cell according to any one of claims 1-13;
an encapsulation layer covering a surface of the solar cell string; and
a cover plate covering a surface of the encapsulation layer facing away from the solar cell string.

15. A method for manufacturing a solar cell, comprising:
providing a substrate having a front surface and a back surface opposite to the front surface, wherein the back surface includes first regions, second regions and gap regions, the first regions and the second regions are staggered and spaced from each other in a first direction, and each gap region is provided between one first region and one second region adjacent to the first region by recessing toward an interior of the substrate;
forming a first conductive layer over the back surface of the substrate;
performing laser ablation over the back surface of the substrate to remove the first conductive layer located in the second region and the gap region;
forming a second conductive layer over the back surface of the substrate;
forming a first protective layer over a surface of the second conductive layer corresponding to the second region;
removing the second conductive layer not covered by the first protective layer;
removing the first protective layer;
performing texturing to form first pyramidal texture structures on the back surface corresponding to the gap regions, wherein a curved interface region is formed between a side wall of the first conductive layer and/or the second conductive layer and a side wall of the gap region adjacent thereto; and
forming a first electrode on the first conductive layer, and forming a second electrode on the second conductive layer.

## Amended claims

### Amended claims in accordance with Rule 137(2) EPC.

1. A solar cell, comprising:
a substrate (1) having a front surface (2) and a back surface (3) opposite to the front surface (2), wherein the back surface (3) includes first regions (101), second regions (102) and gap regions (4), the first regions (101) and the second regions (102) are staggered and spaced from each other in a first direction, and each gap region (4) is provided between one first region (101) and one second region (102) adjacent to the first region (101);
a first conductive layer (5) formed over the first region (101);
a second conductive layer (6) formed over the second region, wherein the second conductive layer (6) has a conductivity type opposite to the first conductive layer (5);
a first electrode (7) forming electrical contact with the first conductive layer (5);
a second electrode (8) forming electrical contact with the second conductive layer (6); and
first pyramidal texture structures (9) formed on the back surface (3) corresponding to the gap regions (4), wherein a curved interface region (10) is formed between a side wall of the first conductive layer (5) and/or the second conductive layer (6) and a side surface of the gap region (4) adjacent thereto.

2. The solar cell according to claim 1, further comprising a back passivation layer (11) formed over a surface of the first conductive layer (5), a surface of the second conductive layer (6), and a surface of the gap region (4), wherein the first electrode (7) penetrate through the back passivation layer (11) to form electrical contact with the first conductive layer (5), and the second electrode (8) penetrate through the back passivation layer (11) to form electrical contact with the second conductive layer (6).

3. The solar cell according to claim 1, wherein a front passivation layer (11) is formed over the front surface (2) of the substrate (1).

4. The solar cell according to claim 1, wherein the substrate (1) is an N-type substrate, the first conductive layer (5) comprises a P-type doped layer, and the second conductive layer (6) comprises an N-type doped layer.

5. The solar cell according to claim 1, wherein a dielectric layer (13) is formed between at least one of the first conductive layer (5) or the second conductive layer (6) and the back surface (3) of the substrate (1).

6. The solar cell according to claim 5, wherein the dielectric layer (13) comprises silicon oxide, aluminum oxide, hafnium oxide, silicon nitride, or silicon oxynitride.

7. The solar cell according to claim 5, wherein the dielectric layer (13) has a thickness in a range of 0.5 nm to 3 nm.

8. The solar cell according to claim 5, wherein the dielectric layer (13) does not cover the back surface (3) of the substrate (1) corresponding to the gap regions (4).

9. The solar cell according to claim 1, wherein a distance between a top surface and a bottom surface of the first pyramidal texture structures (9) ranges from 1 µm to 5 µm.

10. The solar cell according to claim 1, wherein an extent of the curved interface region (10) in the first direction ranges from 3 µm to 15 µm, or a distance between a top surface and a bottom surface of the curved interface region (10) ranges from 2 µm to 5 µm.

11. The solar cell according to claim 1, wherein an extent of the gap region (4) in the first direction ranges from 50 µm to 200 µm, or an extent of the gap region (4) in a normal direction of the back surface (3) of the substrate (1) ranges from 1 µm to 6 µm.

12. The solar cell according to claim 1, wherein at least part of a surface of the curved interface region (10) includes a plurality of protruding texture structures.

13. The solar cell according to claim 1, wherein a ratio of an area of the gap region (4) to an area of the back surface (3) of the substrate (1) ranges from 10% to 35%.

14. A photovoltaic module, comprising:
a solar cell string (17) including a plurality of solar cells, wherein at least one of the plurality of solar cells is the solar cell according to any one of claims 1-13;
an encapsulation layer (18) covering a surface of the solar cell string (17); and
a cover plate (19) covering a surface of the encapsulation layer (18) facing away from the solar cell string (17).

15. A method for manufacturing a solar cell, comprising:
providing a substrate (1) having a front surface (2) and a back surface (3) opposite to the front surface (2), wherein the back surface (3) includes first regions (101), second regions (102) and gap regions (4), the first regions (101) and the second regions (102) are staggered and spaced from each other in a first direction, and each gap region (4) is provided between one first region (101) and one second region adjacent to the first region (101);
forming a first conductive layer (5) over the back surface (3) of the substrate (1);
performing laser ablation over the back surface (3) of the substrate (1) to remove the first conductive layer (5) located in the second region and the gap region (4);
forming a second conductive layer (6) over the back surface (3) of the substrate (1);
forming a first protective layer (16) over a surface of the second conductive layer (6) corresponding to the second region;
removing the second conductive layer (6) not covered by the first protective layer (16);
removing the first protective layer (16);
performing texturing to form first pyramidal texture structures (9) on the back surface (3) corresponding to the gap regions (4), wherein a curved interface region (10) is formed between a side wall of the first conductive layer (5) and/or the second conductive layer (6) and a side surface of the gap region (4) adjacent thereto; and
forming a first electrode (7) on the first conductive layer (5), and forming a second electrode (8) on the second conductive layer (6).
